Europäisches Patentamt

**European Patent Office**

**Office européen des brevets**

(19)

(11) Veröffentlichungsnummer: **0 009 098**
**B1**

(12)         **EUROPÄISCHE PATENTSCHRIFT**

(45) Veröffentlichungstag der Patentschrift: **01.06.83**

(21) Anmeldenummer: **79102719.6**

(22) Anmeldetag: **31.07.79**

(51) Int. Cl.³: **H 01 L 29/40,**
**H 01 L 21/285**

(54) Verfahren zum Herstellen einer Schottky-Sperrschichtdiode und dadurch hergestellte Schottky-Sperrschichtdiode.

(30) Priorität: **22.09.78 US 944815**

(43) Veröffentlichungstag der Anmeldung:
**02.04.80 Patentblatt 80/7**

(45) Bekanntmachung des Hinweises auf die Patenterteilung:
**01.06.83 Patentblatt 83/22**

(84) Benannte Vertragsstaaten:
**DE FR GB**

(56) Entgegenhaltungen:
**IBM TECHNICAL DISCLOSURE BULLETIN, Band 20, Nr. 9, Februar 1978, Seiten 3484—3485 New York, U.S.A. W. K. CHU et al.: "Schottky Barrier Diode Structure and Conductor Metallurgy with Increased Electromigration Resistance"**
**IBM TECHNICAL DISCLOSURE BULLETIN, Band 21, Nr. 3, August 1978, Seiten 1054—1057 New York, U.S.A. W. K. CHU et al.: "Oxygen Gettering in Transition Metals for Stable Low Barrier Height Schottky Diodes"**

(73) Patentinhaber: **International Business Machines Corporation**
**Armonk, N.Y. 10504 (US)**

(72) Erfinder: **Howard, James Kent**
**Cedar Hill Road**
**Fishkill, NY 12524 (US)**
Erfinder: **Turene, Frank Edward**
**Box 477**
**Pleasant Valley, NY 12569 (US)**
Erfinder: **White, James Francis**
**17 Lake View Drive**
**Newburgh, NY 12550 (US)**

(74) Vertreter: **Böhmer, Hans Erich, Dipl.-Ing.**
**Schönaicher Strasse 220**
**D-7030 Böblingen (DE)**

Courier Press, Leamington Spa, England.

# 0 009 098

Verfahren zum Herstellen einer Schottky-Sperrschichtdiode und dadurch hergestellte
Schottky-Sperrschichtdiode

Die Erfindung betrifft ein Verfahren Herstellen einer Schottky-Sperrschichtdiode mit einer auf der Oberfläche eines Siliciumsubstrats liegenden aus einem Übergangsmetall bestehenden Sperrschicht, einer Diffusionssperrchicht und einer aus Aluminium bestehenden Metallisierungsschicht sowie eine dadurch hergestellte Schottky-Sperrschichtdiode. Ein derartiger Aufbau, bei dem die Diffusionsschicht aus einer Schichtenfolge mit Al-Ta-Al-Al+Al$_2$O$_3$ und Ta auf einem Siliciumsubstrat hergestellt wird, die nach einer Wärmebehandlung in Al-TaAl$_3$-Al-TaAl$_3$Ta-Al$_2$O$_3$-Silicium übergeht, ist aus IBM Technical Disclosure Bulletin, Vol. 20, No. 9, Februar 1978, Seiten 3484/85 bekannt.

Die Verwendung von Schottky-Sperrschichtübergängen ist ebenso allgemein bekannt, wie die Verwendung von Schottky-Sperrschichtkontakten in integrierten, monolithischen Schaltungen. Wegen ihrer relativ niedrigen Sperrwirkung in Durchlaßrichtung oder ihrer kleinen Einschaltspannung ist ihre Anwendung in integrierten Schaltungen dann besonders vorteilhaft, wenn die Sättigung von Transistoren verhindert, höhere Einschaltgeschwindigkeiten für digitale Schaltungen erreicht oder schnellere Umschaltgeschwindigkeiten erzielt werden sollen. Da die Potentialschwelle in Durchlaßrichtung dieser Schottky-Dioden umgekehrt proportional zu den Schaltgeschwindigkeiten ist, sind Schottky-Sperrschichtdioden mit niedriger Potentialschwelle in Durchlaßrichtung sehr erwünscht.

In der DE—A 2 754 861 ist ein Verfahren zur Erzielung stabiler Schottky-Sperrschichtdioden beschrieben, das sich dadurch auszeichnet, daß man einen Übergangsmetall-Sperrschichtkontakt (z. B. aus Hafnium, Zirkon, Tantal, Niob, Titan usw.) mit darüberliegenden Teilen eines auf Aluminiumbasis aufgebauten Leitungsmusters umsetzt und dadurch den Sperrschichtkontakt in eine intermetallische Verbindung des Aluminiums mit dem Übergangsmetall umwandelt. Obgleich dieses Verfahren die Herstellung von stabilen Schottky-Sperrschichtdioden mit einer Potentialschwelle in Durchlaßrichtung von etwa 0,67 eV ermöglicht, so sind doch niedrigere Potentialschwellen von beispielsweise etwa 0,5 eV wünschenswert, wie sie beispielsweise zunänchst bei Verwendung von Tantal als Sperrschichtkontakt mit Silicium auftritt. Unglücklicherweise ist die Verwendung von aus Aluminium bestehenden Leitungsmustern in Verbindung mit Sperrschichtkontakten von Übergangsmetallen, insbesondere Tantal, sehr stark eingeschränkt wegen der raschen und leichten Reaktion zwischen Aluminium und einigen Übergangsmetallen während Temperaturzyklen, wie sie normalerweise bei Herstellungsverfahren von integrierten Schaltungen auftreten. Diese Reaktionen (beispielsweise zwischen Tantal und Aluminium) bilden intermetallische Verbindungen (z. B. TaAl$_3$), die die Potentialschwelle nach einer Hochtemperaturbehandlung nach den Werten für Aluminium verschiebt, d. h. von etwa 0,5 eV für auf Silicium niedergeschlagenes Tantal nach etwa 0,7 eV für Aluminium nach der Reaktion. Es wäre dagegen erwünscht, daß bei einer solchen Wärmebehandlung stabile niedrige Werte für Potentialschwellen erhalten blieben, die nahe an den Werten von Tantal liegen. Dies wird erfindungs gemäß in der Weise erreicht wie sie in den Patentansprüchen und 2 gekennzeichnet ist. Weitere Ausgestaltungen der Erfindung sind den Patentansprüchen 3 bis 5 zu entnehme.

Die Erfindung wird nunmehr anhand eines Ausführungsbeispiels in Verbindung mit den beigefügten Zeichnungen näher erläutert.

In den Zeichnungen zeigt.

Fig. 1 eine Teilquerschnittsansicht einer Ausführungsform einer erfindungsgemäß aufgebauten Schottky-Sperrschichtdiode und

Fig. 2 in isometrischer Darstellung die Anordnung von Schottky-Sperrschichtdioden gemäß der Erfindung.

Eine Schottky-Sperrschichtdiode 1 mit einem Übergangsmetall-Sperrschichtkontakt 2 und einem auf Aluminiumbasis aufgebauten Leitungsmuster 3 weist thermisch stabile Werte von etwa 0,5 eV (z. B. bis etwa 500°C) dadurch auf, daß eine dazwischen liegende Diffusionssperrschicht 4 benutzt wird, die aus einer intermetallischen Verbindung von Aluminium und dem Übergangsmetall des Sperrschichtkontakts besteht.

Der hier verwendete Ausdruck "intermetallische Verbindung" ist mehr als nur eine einfache Mischung in Form einer Legierung. Vielmehr soll dieser Ausdruck auf einen Stoff hinweisen, der aus Atomen von zwei verschiedenen Elementen mit bestimmten Verhältnissen der Atome der die Verbindung bildenden Elemente besteht, die sich am besten durch eine chemische Formel darstellen läßt. In dem Buch "Elements of Physical Metallurgy" von A. G. Guy, veröffentlicht durch Addison-Wesley, 1951, findet sich auf Seite 89 eine Definition einer intermetallischen Verbindung wie folgt:

"Phasen, deren chemische Zusammensetzung zwischen den beiden reinen Metallen liegen und deren Kristallstrukturen von denen der reinen Metalle verschieden sind. Dieser Unterschied in der Kristallstruktur unterschiedet die Zwischenphasen von primären festen Lösungen, die auf dem reinen Metall basieren".

"Einige Zwischenphasen können exakt als intermetallische Verbindungen bezeichnet werden, wenn sie, wie z. B. Mg$_2$Pd, ein festes einfaches Verhältnis von zwei Arten von Atomen aufweisen".

TABELLE I

| | ASTM Karte Nr. (Band 1) | Kristall- struktur | Referenz |
|---|---|---|---|
| Al$_3$Hf | 17-419 | tetragonal | Boller et al. Monatsh Chem. *91,* 1174 (60) |
| Al$_3$Ta | 2-1128 | tetragonal | Brauer, Z. Anorg. Chem. *242,* 9 (1939) |
| Al$_3$Zr | 2-1093 | tetragonal | Brauer, Z. Anorg. Chem. *242,* 15 (1939) |
| Al$_3$Ti | 2-1121 | tetragonal | Brauer, Z. Anorg. Chem. *242,* 4 (1939) |
| Al$_3$Ni | 2-416 | orthorhombisch | Bradley et al., Phil. Mag *23,* 1049 (37) |
| Al$_3$Nb | 13-146 | tetragonal | Brauer, Z. Anorg. Chem. *242,* 1 (1939) |

TABELLE II

| Element | Struktur |
|---|---|
| Al | kubisch flächenzentriert |
| Ta | kubisch raumzentriert |
| HF | hexagonale enge Packung |
| Zr | hexagonale enge Packung |
| Ti | hexagonale enge Packung |
| Nb | kubisch raumzentriert |
| Ni | kubisch flächenzentriert |

Die Tabelle 1 gibt für die intermetallische Verbindung und ihre entsprechende Kristallstruktur einen Hinweis auf eine Literaturstelle, und die Tabelle II gibt die entsprechende Kristallstruktur für die verschieden reinen Elemente an, die bei der Erfindung verwendet werden. Es sollte daher klar sein, daß die hier offenbarten intermetallischen Verbindungen von Aluminium und Übergangsmetallen in der Tat intermetallische Verbindungen und nicht Legierungen sind. Dies wird durch die Tatsache unterstrichen, daß die Kristallstrukturen, d. h. die dreidimensionalen Beziehungen der Atome in den festen Kristallen dieser Verbindungen sich von denen der reinen Metalle oder der Legierungen unterscheiden.

Derzeit bestes Verfahren für die Durchführung der Erfindung

Die erfindungsgemäß aufgebaute Schottky-Sperrschichtdiode 1 wird in einem aus einem P- oder N-leitenden monokristallinen Silicium bestehenden Substrat 5 gebildet, auf dem eine N- oder P-leitende, aus Silicium bestehende Halbleiterschicht 6 epitaxial aufgewachsen wird (beispielsweise mit einer Dotierungskonzentration von etwa $3 \times 10^{16}$ at/cm$^3$) mit einer dielektrischen Schicht 7 (z. B. Siliciumdioxid, SiO$_2$, Siliciumnitrid, Si$_3$N$_4$, oder ein zweifacher Überzug aus SiO$_2$ und Si$_3$N$_4$) und mit einer Öffnung 8, die den Bereich der Schottky-Sperrschichtdiode definiert.

Eine Sperrschicht-Kontaktschicht 2 eines Übergangsmetalls (wie z. B. Tantal, Zirkon, Titan, Hafnium, Niob usw.) wird in der Öffnung 8 der dielektrischen Schicht durch ein geeignetes Verfahren, wie z. B. Kathodenzerstäubung oder Verdampfung niedergeschlagen. Obgleich dieses nicht kritisch ist, kann die aus Übergangsmetall bestehende Schicht 2 bis zu einer Dicke von etwa 10 bis etwa 100 Nanometer niedergeschlagen werden.

Als nächstes wird eine 50 bis 150 Nanometer starke Diffusionssperrschicht 4 aus einer intermetallischen Verbindung des Übergangsmetalls mit Aluminium über der Sperrschicht-Kontaktschicht 2 durch irgendein dafür geeignetes Verfahren, vorzugsweise durch Hochfrequenzzerstäubung aus einer aus einem vorlegierten Material bestehenden Prallplatte, beispielsweise aus einer aus vorlegiertem TaAl$_3$ bestehenden Prallplatte niedergeschlagen. Selbstverständlich läßt sich diese Schicht auch durch Verdampfung oder gemeinsamen Niederschlag aus zwei Quellen zur Herstellung der intermetallischen Phase aufbringen.

Überschüssige Teile der Diffusionssperrschicht 4 und des Sperrschichtkontaktes 2 werden dann in üblicher Weise durch ein Trockenätzverfahren (beispielsweise durch Zerstäubungsätzen) entfernt.

Eine auf Aluminium basierende Metallschicht mit einer Dicke von etwa 500 bis 1000 Nanometer wird beispielsweise durch Verdampfung oder Zerstäubung über dem Substrat aufgetragen und entweder durch trockene oder nasse Ätzverfahren zu einem Muster 3 geätzt, das die Schottky-Sperrschichtdiode mit anderen Bauelementen einer integrierten Schaltung verbindet, wie z. B. in der US-Patentschift 3 900 344 gezeigt.

Die intermetallische Schicht 4 bildet eine wirksame Diffusionssperrschicht, die eine Wechselwirkung zwischen dem Übergangsmetall-Sperrschichtkontakt 2 und dem auf Aluminium-basis aufgebauten Leitungsmuster 3 verhindert. Die für eine Diffusion von Aluminium des Leitungsmusters 3 und des Übergangsmetalls 2 durch die aus der intermetallischen Phase bestehende Sperrschicht 4 hindurch erforderliche Energie beträgt schätzungsweise etwa 1,5 bis 2,0 eV und ist damit wesentlich größer als die bei der Diffusion von Aluminium durch Aluminiumkörner (1,4 eV) oder Aluminium durch Aluminiumkorngrenzen (etwa 0,5 bis 0,6 eV) erforderliche Energie. Es wird erwartet, daß für eine Hochtemperaturbehandlung bei etwa 450°C, wie sie beispielsweise beim Herstellen eines Glasüberzugs oder beim Anlöten zu erwarten ist (beispielswiese etwa 450—500°C), das Aluminium die intermetallische Schicht 4 nicht durchdringen wird, so daß dadurch die niedrige Potentialschwelle des Übergangsmetall-Sperrschichtkontaktes 2 erhalten bleibt. In gleicher Weise ist auch die Diffusion des Übergangsmetalls in das Aluminium beschränkt, so daß der Widerstand der Aluminiumschicht nicht beeinträchtigt wird.

Beispiel 1

In diesem Beispiel wurde TaAl₃ als eine, die Diffusion einschränkende oder verhindernde intermetallische Schicht zwischen einem aus elementarem Tantal bestehenden Sperrschichtkontakt und einem Aluminiumkontakt verwendet. Drei Halbleiterscheiben wurden zur Herstellung von Prüfstrukturen verwendet, die auf einem $N^+$-leitenden Halbleitersubstrat 20 mit einer $N^-$-leitenden Epitaxialschicht 21 aufgebaut wurden, die bis zur einem Niveau von $3 \times 10^{16}$ at/cm³ dotiert waren. Die Epitaxialschicht 21 wurde anschließend mit einer $SiO_2$-Schicht 22 überzogen und eine $Si_3N_4$-Schicht 23 zur Herstellung von Diodenprüflingen 26 mit Öffnungen 24 versehen. Auf einer Halbleiterscheibe mit etwa 10 cm Durchmesser wurden insgesamt 240 Diodenprüflinge hergestellt.

Ein 50 Nanometer dicker Film 27 aus Tantal wurde durch Hochfrequenzzerstäubung auf der Halbleiterscheibe niedergeschlagen, gefolgt von einem 100 Nanometer dicken Überzug 28 aus $TaAl_3$, der durch Hochfrequenzzerstäubung aus einer vorlegierten, aus $TaAl_3$ bestehenden Prallplatte hergestellt worden war. Als nächstes wurde eine 580 Nanometer dicke Schicht einer Aluminiumlegierung mit 4% Kupfergehalt durch Verdampfung niedergeschlagen. Die Al/Cu-Legierungsschicht wurde dann photolithographisch zur Bildung der Dioden-Anoden 30 der Diodenprüflinge 26 geätzt. Daraufhin wurden die Rückseiten der Halbleiterscheiben zur Bildung ohmscher Kontakte 31 für alle drei Halbleiterscheiben mit einem 500 Nanometer dicken Überzug aus der Al-4% Cu-Legierung überzogen.

Zur Bestimmung der Auswirkung des Aufwachsens einer Oxidschicht in Luft auf der ursprünglichen Tantaloberfläche auf die Sperrschichteigenschaften wurde das Vakuum nach dem Niederschlag von Tantal und vor dem Niederschlag von $TaAl_3$ aufgehoben. Außerdem wurde bei einem Lauf nach dem Niederschlag von Tantal das $TaAl_3$ absichtlich durch Ionenbeschuß der $TaAl_3$-Prallplatte für 5 Minuten in einer Argonatmosphäre mit einem 10%igen Volumenanteil an Sauerstoff oxidiert.

Die Bearbeitung wird wie folgt zusammengefaßt:

Lauf   Ta/TaAl₃/Al-Cu als in-situ Niederschlag von Ta und TaAl₃ im Vakuum.

Lauf 2  Ta ohne Vacuum/TaAl₃/Al-Cu, d. h. das Vakuum wurde nach dem Ta-Niederschlag auf Normaldruck zurückgeführt.

Lauf 3  Ta/Oxidation/TaAl₃/Al-Cu als absichtliche Oxidation der aus TaAl₃ bestehenden Prallplatte mit Argon und 10% $O_2$ vor Niederschlag des TaAl₃.

Für die Beendigung der Herstellung wurden alle drei Halbleiterscheiben in vier Teile zerteilt und entsprechende drei Viertel der Halbleiterscheiben wurden gesintert bzw. einer Wärmebehandlung unterzogen bei 400°C für eine Stunde, 450°C für eine Stunde und 500°C für eine Stunde.

Die elektrischen Eigenschaften wurden für 60 Sperrschichtdioden mit niedriger Potentialschwelle je Viertel einer Halbleiterscheibe bestimmt, wobei die Durchschnittswerte in der nachfolgenden Tabelle wiedergegeben sind.

TABELLE III
Lauf 1 (Ta/TaAl₃/Al-Cu)

| | wie nieder-geschlagen | 400°C | 450°C | 500°C |
|---|---|---|---|---|
| Idealitäts-faktor "n" | 1.03 | 1.18 | 1.18 | 1.15 |
| Sperrschicht-potential $\phi_B$, eV in Durchlaßrichtung | 0.592 | 0.442 | 0.472 | 0.510 |
| Serienwiderstand $R_s$, Ohm (Silicium nach Aluminium) | 227 | 89 | 92 | 86 |
| Sperrspannung $V_R$ Volt bei 10 Mikroamp. | 6.4 | 7.2 | 8.7 | 9.5 |

TABELLE VI
Lauf 2 (Ta/Vakuum unterbrochen/TaAl₃/Al-Cu)

| | wie nieder-geschlagen | 400°C | 450°C | 500°C |
|---|---|---|---|---|
| "n" | 1.67 | 1.14 | 1.12 | 1.15 |
| $\phi_B$, eV | 0.428 | 0.483 | 0.516 | 0.509 |
| $R_s$, Ohm | 203 | 88 | 100 | 119 |
| $V_R$, Volt bei 10 Mikroamp. | 6.3 | 9.8 | 5.7 | 11.8 |

TABELLE V
Lauf 3 (Ta/Oxidation/TaAl₃/Al)

| | wie nieder-geschlagen | 400°C | 450°C | 500°C |
|---|---|---|---|---|
| "n" | 4.40 | 1.14 | 1.09 | 1.16 |
| $\phi_B$, eV | 0.356 | 0.470 | 0.506 | 0.518 |
| $R_s$, Ohm | 81Ω | 87Ω | 108Ω | 100Ω |
| $V_R$, Volt bei 10 Mikroamp. | 6.4 | 8.5 | 4.7 | 3.6*+11.7* |

*kennzeichnet eine bimodale Verteilung

Diese Tabellen zeigen, daß alle drei aus TaAl₃ bestehenden Diffusionsschichten eine Wärmebeanspruchung bei 500°C für eine Stunde ausgehalten haben und daß dabei die Gleichförmigkeit der Potentialschwelle von Schottky-Sperrschichtdioden in Durchlaßrichtung beibehalten wurde.

Beispiele 2 und 3

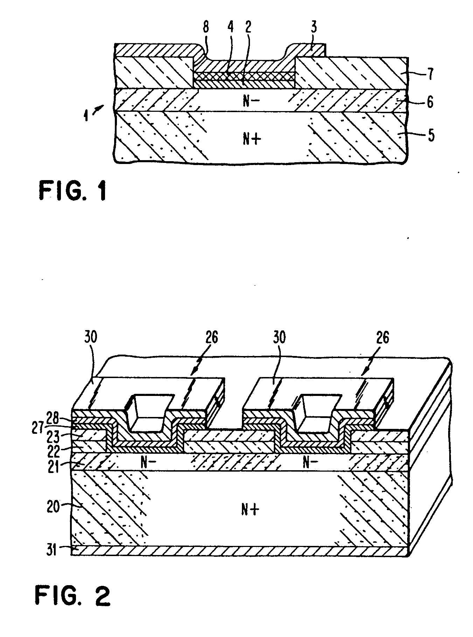

Für diese Beispiele wurden aus Zirkon (Lauf 4) und aus Titan (Lauf 5) bestehende Sperrschicht-Kontaktfilme mit einer Dicke von 50 Nanometern durch Elektronenstrahlverdampfung auf getrennten Siliciumhalbleiterscheiben niedergeschlagen, gefolgt von einer durch Hochfrequenzzerstäubung niedergeschlagenen 100 Nanometer starken Schicht von TaAl₃ über jedem Sperrschichtkontakt auf den getrennten Halbleiterscheiben. Anschließend wurde ein aus Al-4% Cu bestehender Film mit einer Dicke von 850 Nanometer über jeder Diffusionssperrschicht aufgedampft, gefolgt von nassem chemischen Ätzen zur Bildung eines Diodenprüflings, wie er in Fig. 2 gezeigt ist. Anschließend wurde durch Verdampfung auf der Rückseite eine Kathode niedergeschlagen. Dann wurden die Halbleiterscheiben in vier Teile zerteilt, einer Wärmebehandlung unterzogen und dann wurden ihre elektrischen Eigenschaften untersucht. Jedes Viertel einer Halbleiterscheibe enthielt dabei 60 Schottky-Sperrschichtdiodenprüflinge 26.

Die Wärmezyklen für die einzelnen Diodenprüflinge dauerten jeweils eine Stunde in einem Ofen mit einer formierenden Gasatmosphäre bei Temperaturen von 400°C, 450°C und 500°C, wobei die Durchschnittswerte aller Prüflinge in jeder Gruppe von Viertelscheiben in den nachfolgenden Tabellen angegeben sind.

5

# 0 009 098

## TABELLE VI
### Lauf 4 (Ti/TaAl₃/Al-Cu)

Titan-Sperrschichtkontakt (Anode)

|  | wie nieder-geschlagen | 400°C | 450°C | 500°C |
|---|---|---|---|---|
| "n" | 1.68 | 1.32 | 1.43 | 1.41 |
| $\phi_B$, eV | 0.416 | 0.453 | 0.433 | 0.434 |
| $R_s$, Ohm | 54 | 54 | 62 | 53 |
| $V_r$, Volt bei $10^{-5}$ Amp. | 2.1 | 2.8 | 1.5 | 3.1 |

## TABELLE VII
### Lauf 5 (Zr/TaAl₃/Al-Cu)

Zirkon-Sperrschichtkontakt (Anode)

|  | wie nieder-geschlagen | 400°C | 450°C | 500°C |
|---|---|---|---|---|
| "n" | 1.81 | 1.20 | 1.12 | 1.26 |
| $\phi_B$, eV | 0.423 | 0.462 | 0.467 | 0.446 |
| $R_s$, Ohm | 42 | 47 | 51 | 40 |
| $V_R$, Volt bei $10^{-5}$ Amp. | 2.9 | 6.0 | 6.3 | 2.1 |

Die Tatsache, daß die Potentialschwelle in den Tabellen VI und VII während aller Wärmebehandlungszyklen unterhalb von 0.5 eV blieb, zeigt an, daß die aus TaAl₃ bestehende intermetallische Diffusionssperrschicht verhindert, daß die Al-Cu-Legierung mit den aus Ti oder Zr bestehenden Kontakten reagiert. Wenn eine Reaktion stattgefunden hätte, dann hätte sich die Potentialschwelle auf den Wert von Aluminium, beispielsweise etwa 0.7 eV erhöht.

Die in hohem Maße idealen elektrischen Parameter werden darauf zurückgeführt, daß während der durch Elektronenstrahl bewirkten Verdampfung von Titan und Zirkon keine Restgassteuerung vorhanden war.

## Patentansprüche

1. Verfahren zum Herstellen einer Schottky-Sperrschichtdiode mit einer auf der Oberfläche eines Siliciumsubstrats liegenden aus einem Übergangsmetall bestehenden Sperrschicht (2) und einer zwischen der Sperrschicht und einer Aluminium schicht angeordneten Diffusionssperrschicht, dadurch gekennzeichnet, daß die Diffusionssperrschicht bereits als eine einzige aus einer intermetallischen Verbindung eines solchen Übergangsmetalls mit Aluminium bestehende Schicht niedergeschlagen wird und daß darüber die Aluminiumschicht aufgebracht wird.

2. Schottky-Sperrschichtdiode mit einer auf der Oberfläche eines Siliciumsubstrats (5) liegenden aus einem Übergangsmetall bestehenden Sperrschicht (2) und einer zwischen der Sperrschicht und einem Aluminiumschicht angeordneten Diffusionssperrschicht hergestellt nach einem Verfahren gemäß Anspruch 1.

3. Schottky-Sperrschichtdiode nach Anspruch 1, dadurch gekennzeichnet, daß das Übergangsmetall aus der Ta, Hf, Zr, Nb und Ti enthaltenden Gruppe ausgewählt ist.

4. Schottky-Sperrschichtdiode nach Anspruch 2, dadurch gekennzeichnet, daß das Übergangsmetall Tantal ist.

5. Schottky-Sperrschichtdiode nach Anspruch 3, dadurch gekennzeichnet, daß die intermetallische Verbindung aus Tantal und Aluminium mit der Formel TaAl₃ besteht.

## Revendications

1. Procédé pour fabriquer une diode à barrière de Schottky comportant une couche barrière (2) disposée sur la surface d'un substrat de silicium et constituée d'un métal de transition, et une couche de blocage de diffusion disposée entre la couche barrière et une couche d'aluminium, caractérisé en ce que la couche de blocage de diffusion est déjà disposée sous la forme d'une combinaison intermétallique d'un tel métal de transition avec de l'aluminium, et en ce que la couche d'aluminium est déposéz au-dessus de cette couche.

2. Diode à barrière de Schottky comportant une couche barrière (2) disposéz sur la surface d'un substrat de silicium (5) et composée d'un métal de transition et une couche de blocage de diffusion disposé entre la couche barrière et une couche d'aluminium, selon le procédé défini à la revendication 1.

6

3. Diode à barrière de Schottky selon la revendication 2, caractérisée en ce que le métal de transition est choisi dans le groupe comprenant le Ta, le Hf, le Zr, le Nb, et le Ti.

4. Diode à barrière de Schottky selon la revendication 2, caractérisée en ce que le métal de transition est du tantale.

5. Diode à barrière de Schottky selon la revendication 3, caractérisée en ce que la combinaison intermétallique est composée de tantale et d'aluminium selon la formule TaAl$_3$.

**Claims**

1. Method of making a Schottky barrier diode with a barrier layer (2) on the surface of a silicon substrate and consisting of a transition metal, and with a diffusion barrier layer arranged between the barrier layer and an aluminum layer, characterized in that the diffusion barrier layer is already deposited as a single layer consisting of an intermetallic compound of such transition metal with aluminum, and that the aluminum layer is applied thereon.

2. Schottky barrier diode with a barrier layer (2) on the surface of a silicon substrate (5), and consisting of a transition metal, and with a diffusion barrier layer arranged between the barrier layer and an aluminum layer, in accordance with a method as disclosed in claim 1.

3. Schottky barrier diode as claimed in claim 2, characterized in that the transition metal has been selected from the group comprising Ta, Hf, Zr, Nb, and Ti.

4. Schottky barrier diode as claimed in claim 2, characterized in that the transition metal is tantalum.

5. Schottky barrier diode as claimed in claim 3, characterized in that the intermetallic compound consists of tantalum and aluminum having the formula TaAl$_3$.

FIG. 1

FIG. 2